# EUROPÄISCHE PATENTSCHRIFT

(11) **EP 3 106 753 B1**
(45) Veröffentlichungstag und Bekanntmachung des Hinweises auf die Patenterteilung: **21.11.2018**
(21) Anmeldenummer: 16171258.3
(22) Anmeldetag: 25.05.2016
(51) Int. Cl.: F23N 5/12, F23N 5/24, H03K 3/57

(54) **FLAMMENÜBERWACHUNG**
FLAME MONITORING
SURVEILLANCE DE FLAMMES

(30) Priorität: 09.06.2015 DE 102015210507
(43) Veröffentlichungstag der Anmeldung: 21.12.2016
(73) Patentinhaber: Vaillant GmbH, 42859 Remscheid (DE)
(72) Erfinder: Maaß, Andre, 42369 Wuppertal (DE); Dreden, Tim Christopher von, 45257 Essen (DE); Wölfl, Carsten, 42853 Remscheid (DE)
(74) Vertreter: Popp, Carsten

(56) Entgegenhaltungen:
- JP-A- 2000 213 809
- JP-A- 2011 158 111
- JP-B2- 3 061 557
- US-A1- 2006 257 805
- US-A1- 2007 188 971

## Beschreibung

Die Erfindung bezieht sich auf eine Flammenüberwachung insbesondere für öl- oder brenngasbetriebenen Heizgeräte.

Bei öl- oder gasbetriebenen Heizgeräten wird für den Betrieb der Geräte nicht nur Öl beziehungsweise Brenngas, sondern auch elektrischer Strom benötigt. Der Stromverbrauch geht hierbei in die Gesamteffizienz der Geräte ein. Dementsprechend werden Geräte umso schlechter bewertet, desto mehr elektrische Leistung verbraucht wird.

Beim Betrieb der Geräte ist zwischen dem Heizbetrieb und dem Bereitschafts-Modus (Standby) zu unterscheiden. Im Bereitschafts-Modus verbrauchen gemäß dem Stand der Technik viele Komponenten elektrische Leistung, die in diesem Modus nicht benötigt werden. Hierzu gehört unter anderem die Flammenüberwachung, die lediglich dazu dient, im Heizmodus das Vorhandensein einer Flamme zu überprüfen und gegebenenfalls die Brenngas- oder Ölzufuhr abzustellen. Bei der Flammenüberwachung wird die elektrische Leitfähigkeit einer Flamme ausgenutzt. Die Flamme ionisiert die Materie zwischen den Elektroden, wobei sich die ionisierte Materie elektrisch wie eine Diode verhält und lediglich einen Stromfluss in eine Richtung gestattet. Im Falle des Vorhandenseins einer Flamme wird ein elektrischer Stromkreis geschlossen. Ist hingegen keine Flamme vorhanden, so ist der Stromkreis offen und es wird kein Stromfluss erkannt.

Wird eine Wechselspannung an die Flamme angelegt, so ist deren Mittelwert null. Durch die Diodenwirkung wird lediglich eine Wellenseite geleitet, so dass der Mittelwert ungleich null ist.

Gemäß dem Stand der Technik verbraucht die Flammenüberwachung auch im Bereitschafts-Modus elektrische Leistung. Im Bereitschafts-Modus benötigt die Flammenerfassungs-Schaltung ca. 0,5 W elektrische Standby-Leistung. Diese Leistung kann eingespart werden, weil im Standby das Gasventil geschlossen ist.

US2007/0188971 A1 offenbart eine Flammenüberwachung nach dem Stand der Technik.

Der Erfindung liegt somit die Aufgabe zugrunde, die Flammenüberwachung einer Boiler Management Unit (BMU) Steuerelektronik im Bereitschafts-Modus abzuschalten und sicherzustellen, dass diese unmittelbar mit der Beendigung des Bereitschafts-Modus wieder voll funktionsfähig zur Verfügung steht.

Diese Aufgabe wird durch ein Verfahren mit den Merkmalen des Anspruchs 1 oder ein Verfahren mit den Merkmalen des Anspruchs 7.

Vorteilhafte Ausgestaltungen ergeben sich durch die Merkmale der abhängigen Ansprüche.

Ist die Überprüfung positiv ausgefallen, so wird zunächst das Signal der Flammenüberwachungselektrode analysiert.

Vor einem Brennerstart darf kein Stromfluss zwischen der Flammenüberwachungselektrode und Masse vorliegen. Ist dennoch das Signal der Flammenüberwachungselektrode bereits vor einem Start eines mit der Flammenüberwachung verbundenen Brenners größer als ein vorgegebener positiver oder negativer Schwellwert (Grundrauschen der Schaltung), so muss ein Fehler vorliegen, so dass ein Start des Brenners verhindert wird.

Wenn das Signal der Flammenüberwachungselektrode bereits vor einem Start eines mit der Flammenüberwachung verbundenen Brenners außerhalb einer vorgegebenen Spannbreite des Grundrauschens der Schaltung schwankt, muss ebenfalls ein Fehler vorliegen und ein Start des Brenners wird verhindert.

Ist hingegen vor einem Start eines mit der Flammenüberwachung verbundenen Brenners das Signal der Flammenüberwachungselektrode kleiner als ein vorgegebener Schwellwert, so liegt ein ordnungsgemäßer Zustand vor und die Flammenüberwachung befindet sich im Bereitschaftsmodus.

Bei einer Wärmeanforderung können dann eine Zündung und ein Öl- oder Gasventil für einen Brennerstart freigegeben werden.

Bei dem Verfahren zum Ausschalten der Flammenüberwachung wird das Signal der Flammenüberwachungselektrode erfasst. Liegt dieses unterhalb eines vorgegebenen Schwellwertes vor, so ist dies ein Indiz für keine Flamme. Ist zudem ein Gasventil eines mit der Flammenüberwachung verbundenen Brenners geschlossen und liegt keine Wärmeanforderung vor, so wird die Flammenüberwachung über den ersten Schalter abgeschaltet, um im Bereitschaftsmodus keine elektrische Leistung zu verbrauchen.

Die Erfindung wird nun anhand der Figuren detailliert erläutert. Hierbei zeigen
Figur 1 eine Schaltung zur Durchführung der Erfindung
Figur 2 den gemessenen Spannungsverlauf beim Einschalten der Flammenerfassungsschaltung

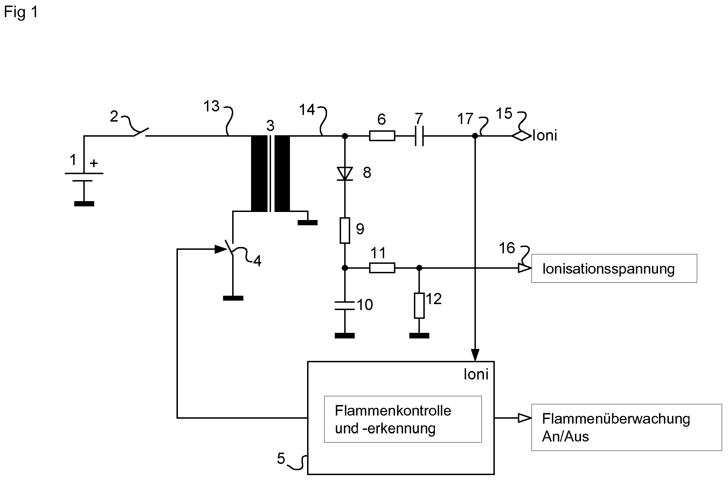

Figur 1 zeigt eine elektronische Schaltung, welche zur Überwachung des lonisationssignals geeignet ist. Das Grundprinzip des Flammenwächters basiert auf einem step up Wandler. Hier wird eine kleine Spannung z.B. 24V über einen step up Wandler auf eine höhere Spannung von ca. 200V transformiert.

Ein Übertrager 3 ist primärseitig über eine Eingangsleitung 13, in der sich ein erster Schalter 2 zum Software-gestützten Ein- und Ausschalten der Schaltung befindet, mit einer Spannungsquelle 1 sowie über einen zweiten Schalter 4 mit Masse verbunden. Eine Flame control and detection Einheit 5 steuert über ein PWM (Puls Weiten Moduliertes) Signal den zweiten Schalter 4 an; somit wird der Übertrager 3 pulsierend (ein- und ausschaltend) bestromt. Somit kann ein Strom von der Spannungsquelle 1 über den ersten Schalter 2 und die Eingangsleitung 13 in den Übertrager 3 und dann weiter über den gepulsten zweiten Schalter 4 fließen. Dadurch wird ein pulsendes Magnetfeld im Übertrager 3 erzeugt. Dieses pulsende Magnetfeld induziert ein Wechselfeld im Übertrager 3. Durch dieses Wechselfeld wird sekundärseitig an der Ausgangsseite des Übertragers 3 eine Wechselspannung auf eine Ausgangsleitung 14 erzeugt. Der Übertrager 3 ist ferner sekundärseitig mit Masse verbunden. Der Übertrager 3 ist so aufgebaut, das der Ausgang des Übertragers 3 eine höhere Spannung am Ausgang der Ausgangsleitung 14 erzeugt als er mittels Spannungsquelle 1 gespeist wird. Diese Wechselspannung wird über zwei Schutzimpedanzen (erster Widerstand 6 und erster Kondensator 7) sowie über eine Flammenüberwachungsleitung 17 an eine Flammenüberwachungselektrode loni 15 weitergeleitet. Die Flammenüberwachungselektrode loni 15 wird bei einem Brenner an einer Stelle positioniert, an welcher beim Vorhandensein einer Flamme diese anliegt, so dass die Flammenüberwachungselektrode loni 15 einen Stromfluss in der elektrisch leitenden Flamme zur Masse erfassen kann.

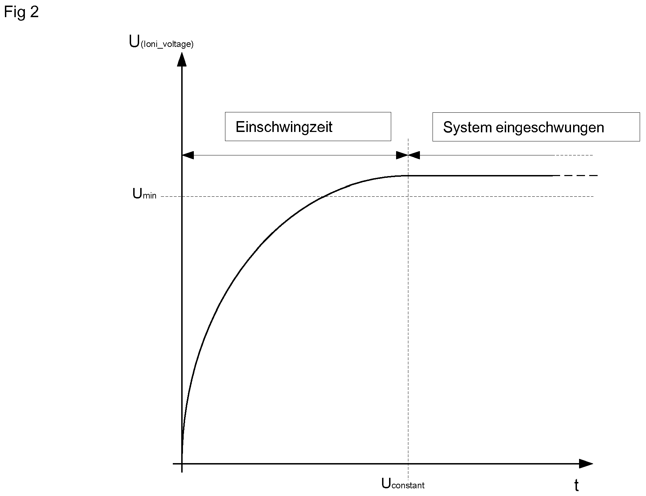

Ob der step up Wandler funktioniert und eingeschwungen ist, wird über einen Ausgang loni_voltage 16 ausgewertet. Hierfür wird von der Spannung in der Leitung 14 am Ausgang des Übertragers 3 Strom über eine Diode 8 und einen zweiten Widerstand 9 auf einen zweiten Kondensator 10 geleitet. Wenn der step up Wandler über den ersten Schalter 2 eingeschaltet wird, lädt sich der zweite Kondensator 10 wie in Figur 2 dargestellt, auf. Zwischen dem zweiten Widerstand 9 und dem zweiten Kondensator 10 ist eine Verbindung, welche über einen dritten Widerstand 11 zum Ausgang loni_voltage 16 führt. Ein vierter Widerstand 12 parallel zum Ausgang loni_voltage 16 bildet zusammen mit dem dritten Widerstand 11 einen Spannungsteiler.

Die Spannung am zweiten Kondensator 10 wird über den Spannungsteiler aus dem dritten Widerstand 11 und dem vierten Widerstand 12 an den Ausgang 16 loni_voltage ausgegeben. Dieses Signal kann mit einem Analogwandler von einem nicht dargestellten Controller ausgewertet werden. Wenn die Spannung sich nicht mehr ändert (U_{constant}) und man eine Mindestspannung Uₘᵢₙ erreicht hat, gilt der step up Wandler und der Flammenwächter als eingeschwungen. Im ordnungsgemäßen Betriebszustand muss dabei eine Mindestspannung Uₘᵢₙ überschritten sein.

Um einen sicheren Wiederanlauf der Flammendetektion in Hardware und Software zu gewährleisten, wird die Stromaufnahme der Flammenerfassungs-Schaltung mit Hilfe der von der Schaltung wie oben beschrieben angelegten lonisationsspannung überwacht. Dabei wird die absolute Spannung, als auch die Stabilität des Signals geprüft.

Ist der sichere Betrieb der Flammenerfassungs-Schaltung sichergestellt, was anhand der Überschreitung der Mindestspannung Uₘᵢₙ am Ausgang 16 loni_voltage sowie der Einhaltung einer maximalen Schwankung der Spannung erkannt wird, wird die Flammendetektion an der Flammenüberwachungselektrode loni 15 softwareseitig gestartet.

Kann kein stabiles Signal an der Flammenüberwachungselektrode loni 15 erkannt werden oder wird trotz verriegeltem Gasventil dauerhaft eine Flamme erkannt, so ist die Flammenerfassungs-Hardware fehlerhaft und das Gerät wird verriegelt.

Wird keine Flamme an der Flammenüberwachungselektrode loni 15 erkannt, was daran erkannt wird, dass eine Mindestspannung nicht anliegt, so ist ein definierter und sicherer Zustand hergestellt und die nicht dargestellte Zündung und das ebenfalls nicht dargestellte Gasventil können freigegeben werden.

Hierzu wird bei Gebläsebrennern in bekannter Weise das Gebläse mit einer vorgegebenen Drehzahl gestartet, die Zündung eingeschaltet und anschließend das Gasventil definiert geöffnet. Nach einer erfolgreichen Zündung wird mittels der Flammenüberwachungselektrode loni 15 erkannt, dass die Flamme - wie oben beschrieben - einen Stromkreis schließt. Das Gasventil bleibt sodann während der Wärmeanforderung geöffnet.

Kann hingegen mittels der Flammenüberwachungselektrode loni 15 kein stabiles Flammensignal erkannt werden oder wird trotz verriegeltem Gasventil dauerhaft eine Flamme erkannt, so ist die Flammenerfassungs-Hardware fehlerhaft und das Gerät wird verriegelt.

Durch dieses Verfahren kann auch sicherheitsrelevant der Flammenwächter auf seine Funktion überprüft werden.

Zum Ausschalten der Flammenerfassung im Bereitschafts-Modus kann in der Software die Flammenerfassung deaktiviert werden. Der Bereitschafts-Modus liegt vor, wenn keine Wärmeanforderung vorliegt und ein sicherheitsrelevanter Abschalttest des Gasventils erfolgreich durchlaufen wurde. Es muss vor der Abschaltung der Flammenerfassungs-Hardware sichergestellt sein, dass bei geschlossenem Gasventil, was anhand einer entsprechenden Bestromung des Ventils erkannt wird, keine Flamme vorhanden ist. Dies wird mittels der Flammenüberwachungselektrode loni 15 ermittelt; erfasst diese kein Signal beziehungsweise liegt deren Signal im Bereich eines Grundrauschens, so ist keine Flamme vorhanden. Liegt keine Wärmeanforderung vor, ist das Gasventil geschlossen und wird keine Flamme erkannt, so kann die Flammenüberwachung über den ersten Schalter 2 abgeschaltet werden. Die Zündung und das Gasventil werden zusätzlich verriegelt.

Wird nun eine Wärmeanforderung neu erfasst, so muss zunächst vor einem Brennerstart zunächst erst die Flammenerfassung in oben beschriebener Weise reaktiviert und überprüft werden.

Bei Brenner müssen sicherheitsrelevante Elektronik-Module auf Kurzschluss und Unterbrechung auf Bauteilebene geprüft werden. Hierbei darf kein gefährlicher Zustand entstehen. Bei dem erfindungsgemäßen Verfahren würde bei einem derartigen Fehler (Kurzschluss und Unterbrechung) das Signal am Ausgang 16 loni_voltage nicht hochlaufen; das Ausgangssignal hätte vielmehr ungefähr 0 V.

### Bezugszeichenliste

1 Spannungsquelle
2 erster Schalter
3 Übertrager
4 zweiter Schalter
5 Flame control and detection Einheit
6 erster Widerstand
7 erster Kondensator
8 Diode
9 zweiter Widerstand
10 zweiter Kondensator
11 dritter Widerstand
12 vierter Widerstand
13 Eingangsleitung
14 Ausgangsleitung
15Flammenüberwachungselektrode loni
16 Ausgang loni_voltage
17 Flammenüberwachungsleitung

## Patentansprüche

1. Verfahren zum Einschalten und Überprüfen einer Flammenüberwachung mit einer Spannungsquelle (1), welche über eine Eingangsleitung (13), in der sich ein erster Software-gestützter Schalter (2) zum Ein- und Ausschalten der Schaltung befindet, mit einem Übertrager (3) primärseitig verbunden ist, wobei der Übertrager (3) ebenfalls primärseitig über einen zweiten Schalter (4) mit Masse verbunden ist, wobei der zweite Schalter (4) mit einer Flame control and detection Einheit (5) verbunden ist, wobei der Übertrager (3) sekundärseitig einerseits mit Masse und andererseits mit einer Ausgangsleitung (14) verbunden ist, wobei die Ausgangsleitung (14) über eine Flammenüberwachungsleitung (17) mit einer Flammenüberwachungselektrode loni (15) verbunden ist, wobei die Ausgangsleitung (14) ferner zumindest unter Einbeziehung eines Spannungsteilers (11, 12) mit einem Ausgang loni_voltage (16) verbunden ist, **dadurch gekennzeichnet, dass** nach Betätigung des ersten Schalters (2) die Flame control and detection Einheit (5) den zweiten Schalter (4) gepulst ein- und ausschaltet, wobei das Signal am Ausgang loni_voltage (16) ausgewertet wird, wobei in dem Fall, in dem das Signal am Ausgang loni_voltage (16) konstant bleibt oder lediglich innerhalb einer vorgegebenen Spannbreite schwankt und zugleich eine vorgegebene Mindestspannung Uₘᵢₙ überschritten ist, auf einen ordnungsgemäßen Zustand Betriebszustand geschlussfolgert wird.

2. Verfahren zum Einschalten und Überprüfen einer Flammenüberwachung nach Anspruch 1,
**dadurch gekennzeichnet, dass** anschließend das Signal der Flammenüberwachungselektrode loni (15) analysiert wird.

3. Verfahren zum Einschalten und Überprüfen einer Flammenüberwachung nach Anspruch 2,
**dadurch gekennzeichnet, dass** wenn das Signal der Flammenüberwachungselektrode loni (15) größer als ein vorgegebener Schwellwert ist, ein Fehler erkannt und ein Start eines mit der Flammenüberwachung verbundenen Brenners verhindert wird.

4. Verfahren zum Einschalten und Überprüfen einer Flammenüberwachung nach Anspruch 2,
**dadurch gekennzeichnet, dass** wenn das Signal der Flammenüberwachungselektrode loni (15) außerhalb einer vorgegebenen Spannbreite schwankt, ein Fehler erkannt und ein Start eines mit der Flammenüberwachung verbundenen Brenners verhindert wird.

5. Verfahren zum Einschalten und Überprüfen einer Flammenüberwachung nach Anspruch 2,
**dadurch gekennzeichnet, dass** wenn das Signal der Flammenüberwachungselektrode loni (15) kleiner als ein vorgegebener Schwellwert ist, ein ordnungsgemäßer Zustand erkannt wird und die Flammenüberwachung sich im Bereitschaftsmodus befindet.

6. Verfahren zum Einschalten und Überprüfen einer Flammenüberwachung nach Anspruch 5,
**dadurch gekennzeichnet, dass** bei einer Wärmeanforderung eine Zündung und ein Öl- oder Gasventil freigegeben werden können.

7. Verfahren zum Ausschalten und Überprüfen einer Flammenüberwachung mit einer Spannungsquelle (1), welche über eine Eingangsleitung (13), in der sich ein erster Software-gestützter Schalter (2) zum Ein- und Ausschalten der Schaltung befindet, mit einem Übertrager (3) primärseitig verbunden ist, wobei der Übertrager (3) ebenfalls primärseitig über einen zweiten Schalter (4) mit Masse verbunden ist, wobei der zweite Schalter (4) mit einer Flame control and detection Einheit (5) verbunden ist, wobei der Übertrager (3) sekundärseitig einerseits mit Masse und andererseits mit einer Ausgangsleitung (14) verbunden ist, wobei die Ausgangsleitung (14) über eine Flammenüberwachungsleitung (17) mit einer Flammenüberwachungselektrode loni (15) verbunden ist, wobei die Ausgangsleitung (14) ferner zumindest unter Einbeziehung eines Spannungsteilers (11, 12) mit einem Ausgang loni_voltage (16) verbunden ist, **dadurch gekennzeichnet, dass** wenn das Signal der Flammenüberwachungselektrode loni (15) unterhalb eines vorgegebenen Schwellwertes liegt, ein Gasventil eines mit der Flammenüberwachung verbundenen Brenners geschlossen ist und keine Wärmeanforderung vorliegt, die Flammenüberwachung über den ersten Schalter (2) abgeschaltet wird.

8. Verfahren zum Einschalten und Überprüfen einer Flammenüberwachung nach Anspruch 7,
**dadurch gekennzeichnet, dass** die Zündung und / oder das Gasventil eines mit der Flammenüberwachung verbundenen Brenners verriegelt werden.

## Claims

1. Method for switching on and controlling a flame monitoring comprising a voltage source (1) which is connected on the primary side to a transformer (3) via a power input (13), in which a first software-protected switch (2) for switching on and off the circuit is found, wherein the transformer (3) is also connected on the primary side to ground via a second switch (4), wherein the second switch (4) is connected to a flame control and detection unit (5), wherein the transformer (3) is connected on the secondary side on the one hand to ground and on the other hand to an output cable (14), wherein the output cable (14) is connected to a flame monitoring ionisation electrode (15) via a flame monitoring cable (17), wherein the output cable (14) is further connected to an ioni_voltage output (16) at least including a voltage distributor (11, 12), **characterised in that** after actuation of the first switch (2) the flame control and detection unit (5) turns the second switch (4) on and off in a pulsed manner, wherein the signal is evaluated on the ioni_voltage output (16), wherein in the case that the signal remains constant or only fluctuates within a predetermined voltage range and at the same time a predetermined minimum voltage Uₘᵢₙ is exceeded, an operating state is inferred from a regular state.

2. Method for switching on and controlling a flame monitoring according to claim 1,
**characterised in that** subsequently the signal from the flame monitoring ionisation electrode (15) is analysed.

3. Method for switching on and controlling a flame monitoring according to claim 2,
**characterised in that** if the signal from the flame monitoring ionisation electrode (15) is greater than a predetermined threshold value, a fault is recognised and a starting of a burner connected to the flame monitoring is prevented.

4. Method for switching on and controlling a flame monitoring according to claim 2,
**characterised in that** if the signal from the flame monitoring ionisation electrode (15) fluctuates outside of the predetermined voltage range, a fault is recognised and a starting of a burner connected to the flame monitoring is prevented.

5. Method for switching on and controlling a flame monitoring according to claim 2,
**characterised in that** if the signal from the flame monitoring ionisation electrode (15) is less than a predetermined threshold value, a regular state is recognised and the flame monitoring is in standby mode.

6. Method for switching on and controlling a flame monitoring according to claim 5,
**characterised in that** when there is a heat requirement, an ignition and an oil and gas valve can be released.

7. Method for switching off and controlling a flame monitoring comprising a voltage source (1), which is connected on the primary side to a transformer (3) via a power input (13), in which a first software-protected switch (2) for switching on and off the circuit is found, wherein the transformer (3) is also connected on the primary side to ground via a second switch (4), wherein the second switch (4) is connected to a flame control and detection unit (5), wherein the transformer (3) is connected on the secondary side on the one hand to ground and on the other hand to an output cable (14), wherein the output cable (14) is connected to a flame monitoring ionisation electrode (15) via a flame monitoring cable (17), wherein the output cable (14) is further connected to an ioni_voltage output (16) at least including a voltage distributor (11, 12), **characterised in that** if the signal from the flame monitoring ionisation electrode (15) is below a predetermined threshold value, a gas valve of a burner connected to the flame monitor is closed and there is no heat requirement, the flame monitoring is turned off via the first switch (2).

8. Method for switching on and controlling a flame monitoring according to claim 7,
**characterised in that** the ignition and/or gas valve of a burner connected to the flame monitoring are locked.

## Revendications

1. Procédé servant à activer et à contrôler une surveillance de flamme avec une source de tension (1), qui est reliée côté primaire à un transmetteur (3) par l'intermédiaire d'un conduit d'entrée (13), dans lequel se trouve un premier commutateur (2) assisté par un logiciel servant à activer et à désactiver le circuit, dans lequel le transmetteur (3) est relié à la masse également côté primaire par l'intermédiaire d'un deuxième commutateur (4),
dans lequel le deuxième commutateur (4) est relié à une unité de flame control and detection (5),
dans lequel le transmetteur (3) est relié côté secondaire d'une part à la masse et d'autre part à un conduit de sortie (14),
dans lequel le conduit de sortie (14) est relié à une électrode de surveillance de flamme d'ionisation (15) par l'intermédiaire d'un conduit de surveillance de flamme (17),
dans lequel le conduit de sortie (14) est relié en outre à une sortie loni_voltage (16) au moins en intégrant un diviseur de tension (11, 12),
**caractérisé en ce qu'**après l'actionnement du premier commutateur (2), l'unité de flame control and detection (5) active et désactive de manière pulsée le deuxième commutateur (4),
dans lequel le signal est évalué au niveau de la sortie loni_voltage (16),
dans lequel dans le cas où le signal reste constant au niveau de la sortie loni_voltage (16) ou fluctue seulement dans une plage spécifiée et dépasse dans le même temps une tension minimale Uₘᵢₙ spécifiée, un état de fonctionnement conforme est déduit.

2. Procédé servant à activer et à contrôler une surveillance de flamme selon la revendication 1,
**caractérisé en ce qu'**après le signal de l'électrode de surveillance de flamme d'ionisation (15) est analysé.

3. Procédé servant à activer et à contrôler une surveillance de flamme selon la revendication 2,
**caractérisé en ce que** quand le signal de l'électrode de surveillance de flamme d'ionisation (15) est supérieur à une valeur de seuil spécifiée, un dysfonctionnement est identifié et un démarrage d'un brûleur relié à la surveillance de flamme est empêché.

4. Procédé servant à activer et à contrôler une surveillance de flamme selon la revendication 2,
**caractérisé en ce que** quand le signal de l'électrode de contrôle de flamme d'ionisation (15) fluctue en dehors d'une plage spécifiée, un dysfonctionnement est identifié et un démarrage d'un brûleur relié à la surveillance de flamme est empêché.

5. Procédé servant à activer et à contrôler une surveillance de flamme selon la revendication 2,
**caractérisé en ce que** quand le signal de l'électrode de surveillance de flamme d'ionisation (15) est inférieur à une valeur de seuil spécifiée, un état conforme est identifié et la surveillance de flamme se trouve dans le mode d'attente.

6. Procédé servant à activer et à contrôler une surveillance de flamme selon la revendication 5,
**caractérisé en ce qu'**en présence d'une demande de chaleur, un allumage et une soupape d'huile ou de gaz peuvent être libérés.

7. Procédé servant à désactiver et à contrôler une surveillance de flamme avec une source de tension (1), qui est reliée côté primaire à un transmetteur (3) par l'intermédiaire d'un conduit d'entrée (13), dans lequel se trouve un premier commutateur (2) assisté par un logiciel servant à activer et à désactiver le circuit, dans lequel le transmetteur (3) est relié à la masse également côté primaire par l'intermédiaire d'un deuxième commutateur (4),
dans lequel le deuxième commutateur (4) est relié à une unité de flame control and detection (5),
dans lequel le transmetteur (3) est relié côté secondaire d'une part à la masse et d'autre part à un conduit de sortie (14),
dans lequel le conduit de sortie (14) est relié à une électrode de surveillance de flamme d'ionisation (15) par l'intermédiaire d'un conduit de surveillance de flamme (17),
dans lequel le conduit de sortie (14) est relié en outre à une sortie loni_voltage (16) au moins en intégrant un diviseur de tension (11, 12),
**caractérisé en ce que** quand le signal de l'électrode de surveillance de flamme d'ionisation (15) est inférieur à une valeur de seuil spécifiée, une soupape de gaz d'un brûleur relié à la surveillance de flamme est fermée et aucune demande de chaleur n'est présente,
la surveillance de flamme est désactivée par l'intermédiaire du premier commutateur (2).

8. Procédé servant à activer et à contrôler une surveillance de flamme selon la revendication 7,
**caractérisé en ce que** l'allumage et/ou la soupape de gaz d'un brûleur relié à la surveillance de flamme sont verrouillés.
